# EUROPEAN PATENT APPLICATION

(11) **EP 4 644 507 A1**
(43) Date of publication of application: **05.11.2025**
(21) Application number: 23911548.8
(22) Date of filing: 04.12.2023
(51) Int. Cl.: C09K 3/10, C08K 5/55, C08L 27/12, H01L 21/3065

(54) **RUBBER COMPOSITION FOR SEAL MATERIAL**

(30) Priority: 28.12.2022 JP 2022211203
(71) Applicant: VALQUA, Ltd., Shinagawa-ku Tokyo 141-6024 (JP)
(72) Inventor: NOGUCHI, Masamune, Gojo-shi, Nara 637-0014 (JP); OSUMI, Naoki, Gojo-shi, Nara 637-0014 (JP)
(74) Representative: Vossius & Partner Patentanwälte Rechtsanwälte mbB
(86) International application number: PCT/JP2023/043214
(87) International publication number: WO 2024/142767

(57) **Abstract**

The present invention relates to: a rubber composition for a seal material containing a crosslinkable rubber component and a donor-acceptor type molecular compound; a seal material containing a crosslinked product of the rubber composition for a seal material; and an O ring, a member for a semiconductor manufacturing apparatus, and a seal material for a semiconductor manufacturing apparatus, each of which contains the seal material. The present invention can provide a rubber composition for a seal material that is for use in forming a seal material usable in a semiconductor manufacturing apparatus using plasma, and exhibits excellent antistatic properties.

## Description

### TECHNICAL FIELD

The present invention relates to a rubber composition for a seal material, and further relates to a seal material, an O ring, a member for a semiconductor, and a seal material for a semiconductor.

### BACKGROUND ART

As a seal material for use in a semiconductor manufacturing apparatus, seal materials having antistatic properties have been proposed (PTL 1: Japanese Patent Laying-Open No. 2007-137977, PTL 2: Japanese Patent Laying-Open No. 2022-1642, PTL 3: Japanese National Patent Publication No. 2016-516880, PTL 4: Japanese Patent Laying-Open No. 2020-128544, PTL 5: Japanese Patent Laying-Open No. 2020-125491, PTL 6: Japanese Patent Laying-Open No. 2019-85475).

### CITATION LIST

### PATENT LITERATURE

PTL 1: Japanese Patent Laying-Open No. 2007-137977
PTL 2: Japanese Patent Laying-Open No. 2022-1642
PTL 3: Japanese National Patent Publication No. 2016-516880
PTL 4: Japanese Patent Laying-Open No. 2020-128544
PTL 5: Japanese Patent Laying-Open No. 2020-125491
PTL 6: Japanese Patent Laying-Open No. 2019-85475

### SUMMARY OF INVENTION

### TECHNICAL PROBLEM

As a seal material for use in a semiconductor manufacturing apparatus using plasma, a perfluoroelastomer (FFKM) or a fluororubber (FKM) is used in many cases. On the other hand, a perfluoroelastomer (FFKM) and a fluororubber (FKM) are easily charged, and tend to easily collect dust and the like in the production process of the seal material, and as a result, can be a cause of particles in the semiconductor manufacturing process in some cases.

A rubber composition containing a conductive additive such as acetylene black or Ketchen black described in PTL 1 tends to be difficult to use in application to a semiconductor manufacturing apparatus requiring cleanness because it is not stabilized in electric properties depending on a dispersion state of the conductive additive, the strength thereof is increased too much by filling, and carbon is easily precipitated through etching performed in a plasma environment.

Although PTLs 2 to 6 propose ionic liquids as an antistatic agent for use in a seal material, the ionic liquids are difficult to exhibit antistatic properties in some cases depending on the type of a rubber component contained in the seal material.

An object of the present invention is to provide a rubber composition for a seal material that is for use in forming a seal material usable in a semiconductor manufacturing apparatus using plasma, and exhibits excellent antistatic properties.

### SOLUTION TO PROBLEM

The present invention provides a rubber composition for a seal material as follows:
[1] A rubber composition for a seal material, containing a crosslinkable rubber component, and a donor-acceptor type molecular compound.
[2] The rubber composition for a seal material according to [1], wherein the donor-acceptor type molecular compound is a molecular compound composed of an organic boron-based donor component and an organic nitrogen-based acceptor component.
[3] The rubber composition for a seal material according to [2], wherein the molecular compound composed of an organic boron-based donor component and an organic nitrogen-based acceptor component is represented by the following formula (1): 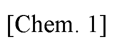 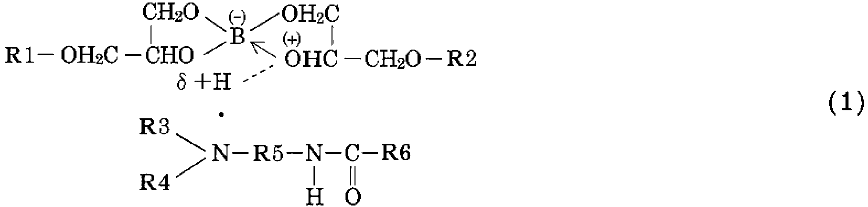 wherein
   R1 and R2 each independently represent a hydrogen atom or -CO-R7,
   at least one of R1 and R2 represents -CO-R7,
   R7 represents an alkyl group having 11 to 21 carbon atoms,
   R3 and R4 each independently represent CH₃, C₂H₅, HOCH₂, HOC₂H₄, or HOCH₂CH(CH₃),
   R5 represents C₂H₄ or C₃H₆, and
   R6 represents an alkyl group having 11 to 21 carbon atoms.
[4] The rubber composition for a seal material according to any one of [1] to [3], wherein the rubber composition contains 0.05 to 30 parts by mass of the donor-acceptor type molecular compound based on 100 parts by mass of the crosslinkable rubber component.
[5] The rubber composition for a seal material according to any one of [1] to [4], wherein the crosslinkable rubber component contains at least one selected from the group consisting of a perfluoroelastomer and a fluororubber, and the perfluoroelastomer has a structural unit derived from a crosslinking site monomer.
[6] The rubber composition for a seal material according to [5], wherein a crosslinking system of the perfluoroelastomer is at least one selected from the group consisting of a peroxide crosslinking system, a triazine crosslinking system, an oxazole crosslinking system, an imidazole crosslinking system, a thiazole crosslinking system, and a bisphenol crosslinking system.
[7] The rubber composition for a seal material according to any one of [1] to [6], further containing a filler, wherein the filler contains polytetrafluoroethylene.
[8] The rubber composition for a seal material according to any one of [1] to [7], wherein a surface potential [V] of the rubber composition for a seal material after crosslinking is -2000 V or more.
[9] A seal material, containing a crosslinked product of the rubber composition for a seal material according to any one of [1] to [8].
[10] An O ring, containing the seal material according to [9].
[11] A member for a semiconductor manufacturing apparatus, containing the seal material according to [9].
[12] A seal material for a semiconductor manufacturing apparatus, containing the seal material according to [9].

### ADVANTAGEOUS EFFECTS OF INVENTION

The present invention provides a rubber composition for a seal material that is for use in forming a seal material usable in a semiconductor manufacturing apparatus using plasma, and exhibits excellent antistatic properties.

### DESCRIPTION OF EMBODIMENTS

### <Rubber Composition for Seal Material>

A rubber composition for a seal material of the present invention contains a crosslinkable rubber component and a donor-acceptor type molecular compound. The rubber composition for a seal material contains the donor-acceptor type molecular compound, and hence can exhibit antistatic properties.

### (1) Donor-acceptor Type Molecular Compound

The donor-acceptor type molecular compound can exchange a positive (+) charge and a negative (-) change generated in the vicinity thereof in a donor-acceptor manner. The rubber composition for a seal material of the present invention contains the donor-acceptor type molecular compound, and hence can erase, while neutralizing, a charge generated in the seal material, and thus, can exhibit excellent antistatic properties. Besides, the donor-acceptor type molecular compound can exhibit excellent antistatic properties in a composition for a seal material containing, as a crosslinkable rubber component, a perfluoroelastomer (FFKM), which has been regarded to be difficult to obtain good antistatic properties with an antistatic agent such **as an ionic** liquid or a conductive additive.

The donor-acceptor type molecular compound used in the present invention is preferably a molecular compound composed of an organic boron-based donor component and an organic nitrogen-based acceptor component from the viewpoint of antistatic properties. The molecular compound composed of an organic boron-based donor component and an organic nitrogen-based acceptor component can possess a donor-acceptor function obtained by the organic boron-based donor component corresponding to and erasing a positive (+) charge, and the organic nitrogen-based acceptor component corresponding to and erasing a negative (-) charge.

The organic boron-based donor component may be, for example, a semipolar boron compound, and is preferably a semipolar boron compound having, in a molecule, at least one straight-chain hydrocarbon group having 5 to 28 carbon atoms. When the semipolar boron compound has at least one straight-chain hydrocarbon group having 5 to 28 carbon atoms, van der Waals force is caused multiply with a matrix of the crosslinkable rubber component, and the antistatic properties of the seal material tend to be exhibited easily for a long period of time. The donor-acceptor type molecular compound may contain one, two or more of the semipolar boron compounds.

The organic boron-based donor component can be one obtained by, for example, reacting a neighboring hydroxy group remaining in an ester disposed between a polyhydric alcohol in which the neighboring hydroxy group remains, and a straight-chain fatty acid with boric acid or a boric acid ester of a lower alcohol; reacting a straight-chain hydrocarbon compound having a neighboring hydroxy group with boric acid or a boric acid ester of a lower alcohol; or reacting, with a straight-chain fatty acid, a hydroxy group remaining after reacting a tri- or higher valent polyhydric alcohol having a neighboring hydroxy group with boric acid or a boric acid ester of a lower alcohol.

Examples of a polyhydric alcohol or a fatty acid partial ester of a polyhydric alcohol include glycerin, a polyglycerin such as diglycerin, triglycerin, or tetraglycerin, 1,2-alkanediol having 14 to 24 carbon atoms, sorbitol, sorbitan, sucrose, pentaerythritol, polypentaerythritol such as dipentaerythritol, or tripentaerythritol, a polyhydric alcohol such as trimethylolethane, trimethylolpropane, polyoxyethylene glycerin, or polyoxyethylene sorbitan, a glycerin higher fatty acid monoester, a polyglycerin higher fatty acid monoester such as a diglycerin higher fatty acid monoester, a triglycerin higher fatty acid monoester, or a tetraglycerin higher fatty acid monoester, a sorbitol higher fatty acid monoester, a sorbitan higher fatty acid monoester, a sucrose higher fatty acid monoester, a pentaerythritol higher fatty acid mono- or diester, a polypentaerythritol higher fatty acid mono- or diester such as a dipentaerythritol higher fatty acid mono- or diester, or a tripentaerythritol higher fatty acid mono- or diester, and a higher fatty acid partial ester of a polyhydric alcohol such as trimethylolethane higher fatty acid monoester, trimethylolpropane higher fatty acid monoester, a polyoxyethylene glycerin higher fatty acid monoester, or a polyoxyethylene sorbitan higher fatty acid monoester (in which the higher fatty acid can be hexanoic acid, octanoic acid, nonanoic acid, decanoic acid, lauric acid, myristic acid, palmitic acid, stearic acid, behenic acid, montanic acid, oleic acid, or erucic acid). Among these, a glycerin higher fatty acid monoester, or a pentaerythritol higher fatty acid mono- or diester is preferred.

The organic boron-based donor component can be, for example, a semipolar boron compound represented by the following formula (a): 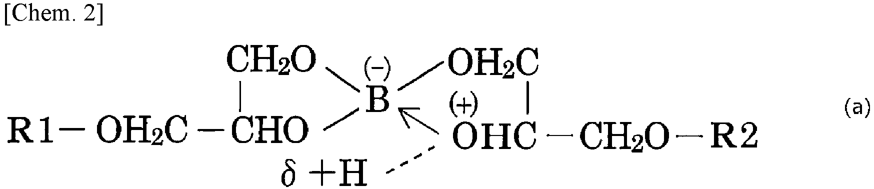
wherein R1 and R2 each independently represent a hydrogen atom or -CO-R7,
at least one of R1 and R2 represents -CO-R7, and
R7 represents an alkyl group having 11 to 21 carbon atoms. In the formula, "δ+" indicates that polarity is present in a covalent bond in a molecule, "(+)" indicates that the electron-donating property of an oxygen atom has increased, "(-)" indicates that the electron-accepting property of a boron atom has increased, "→" indicates an electron withdrawing pathway, and "----" indicates a state in which an interatomic force is weakened.

Examples of the semipolar boron compound represented by formula (a) include compounds represented by the following formulas (a-1) and (a-2):

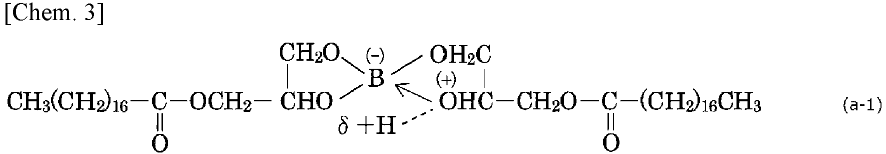

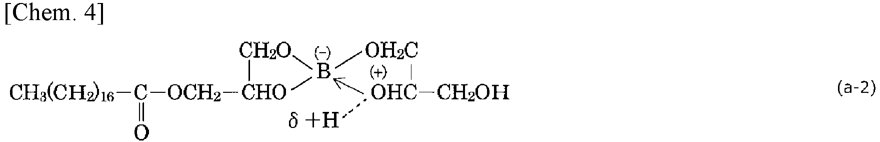

The organic nitrogen-based acceptor component may be, for example, a basic nitrogen compound, and is preferably a basic nitrogen compound having, in a molecule, at least one straight-chain hydrocarbon group having 5 to 28 carbon atoms. When the basic nitrogen compound has, in a molecule, at least one straight-chain hydrocarbon group having 5 to 28 carbon atoms, van der Waals force is caused multiply with a matrix of the crosslinkable rubber component, and the antistatic properties of the seal material tend to be exhibited easily for a long period of time. The donor-acceptor type molecular compound may contain one, two or more of the basic nitrogen compounds.

Examples of the basic nitrogen compound having, in a molecule, at least one straight-chain hydrocarbon group having 5 to 28 carbon atoms include one obtained by adding ethylene oxide to a N-alkyl-substituted primary, secondary, or tertiary amine itself having at least one straight-chain hydrocarbon group, or to a primary or secondary amine having at least one straight-chain hydrocarbon group for bonding N-hydroxyethyl substituent thereto, one obtained by further reacting the terminal hydroxy group with a straight-chain fatty acid, one obtained by adding ethylene oxide to a straight-chain 2-hydroxy aliphatic amine itself resulting from a reaction between ammonia and an epoxidized product of a straight-chain hydrocarbon, or to a primary or secondary straight-chain 2-hydroxy aliphatic amine for bonding a N-hydroxyethyl substituent thereto, and one obtained by reacting a polyalkylene polyamine and a straight-chain fatty acid in a molar ratio for causing one amino group of the polyalkylene polyamine to remain with all of the other amino groups fatty acid amidated.

Examples of the aliphatic amine include octylamine, laurylamine, myristylamine, palmitylamine, stearylamine, oleylamine, cocoamine, tallowamine, soyamine, N,N-dicocoamine, N,N-ditallowamine, N,N-disoyamine, N-lauryl-N,N-dimethylamine, N-myristyl-N,N-dimethylamine, N-palmityl-N,N-dimethylamine, N-stearyl-N,N-dimethylamine, N-coco-N,N-dimethylamine, N-tallow-N,N-dimethylamine, N-soy-N,N-dimethylamine, N-methyl-N,N-ditallowamine, N-methyl-N,N-dicocoamine, N-oleyl-1,3-diaminopropane, N-tallow-1,3-diaminopropane, hexamethylenediamine, N-lauryl-N,N,N-trimethylammonium chloride, N-palmityl-N,N,N-trimethylammonium chloride, N-stearyl-N,N,N-trimethylammonium chloride, N-docosyl-N,N,N-trimethylammonium chloride, N-coco-N,N,N-trimethylammonium chloride, N-tallow-N,N,N-trimethylammonium chloride, N-soy-N,N,N-trimethylammonium chloride, N-lauryl-N,N-dimethyl-N-benzylammonium chloride, N-myristyl-N,N-dimethyl-N-benzylammonium chloride, N-stearyl-N,N-dimethyl-N-benzylammonium chloride, N-coco-N,N-dimethyl-N-benzylammonium chloride, N,N-dioleyl-N,N-dimethylammonium chloride, N,N-dicoco-N,N-dimethylammonium chloride, N,N-ditallow-N,N-dimethylammonium chloride, N,N-disoy-N,N-dimethylammonium chloride, N,N-bis(2-hydroxyethyl)-N-lauryl-N-methylammonium chloride, N,N-bis(2-hydroxyethyl)-N-stearyl-N-methylammonium chloride, N,N-bis(2-hydroxyethyl)-N-oleyl-N-methylammonium chloride, N,N-bis(2-hydroxyethyl)-N-coco-N-methylammonium chloride, N,N-bis(polyoxyethylene)-N-lauryl-N-methylammonium chloride, N,N-bis(polyoxyethylene)-N-stearyl-N-methylammonium chloride, N,N-bis(polyoxyethylene)-N-oleyl-N-methylammonium chloride, N,N-bis(polyoxyethylene)-N-coco-N-methylammonium chloride, N,N-bis(2-hydroxyethyl)lauryl aminobetaine, N,N-bis(2-hydroxyethyl)tridecyl aminobetaine, N,N-bis(2-hydroxyethyl)myristyl aminobetaine, N,N-bis(2-hydroxyethyl)pentadecyl aminobetaine, N,N-bis(2-hydroxyethyl)palmityl aminobetaine, N,N-bis(2-hydroxyethyl)stearyl aminobetaine, N,N-bis(2-hydroxyethyl)oleyl aminobetaine, N,N-bis(2-hydroxyethyl)docosyl aminobetaine, N,N-bis(2-hydroxyethyl)octacosyl aminobetaine, N,N-bis(2-hydroxyethyl)coco aminobetaine, N,N-bis(2-hydroxyethyl)tallow aminobetaine, hexamethylenetetramine,

N-(2-hydroxyethyl)laurylamine, N-(2-hydroxyethyl)tridecylamine, N-(2-hydroxyethyl)myristylamine, N-(2-hydroxyethyl)pentadecylamine, N-(2-hydroxyethyl)palmitylamine, N-(2-hydroxyethyl)stearylamine, N-(2-hydroxyethyl)oleylamine, N-(2-hydroxyethyl)docosylamine, N-(2-hydroxyethyl)octacosylamine, N-(2-hydroxyethyl)cocoamine, N-(2-hydroxyethyl)tallowamine, N-methyl-N-(2-hydroxyethyl)laurylamine, N-methyl-N-(2-hydroxyethyl)tridecylamine, N-methyl-N-(2-hydroxyethyl)myristylamine, N-methyl-N-(2-hydroxyethyl)pentadecylamine, N-methyl-N-(2-hydroxyethyl)palmitylamine, N-methyl-N-(2-hydroxyethyl)stearylamine, N-methyl-N-(2-hydroxyethyl)oleylamine, N-methyl-N-(2-hydroxyethyl)docosylamine, N-methyl-N-(2-hydroxyethyl)octacosylamine, N-methyl-N-(2-hydroxyethyl)cocoamine, N-methyl-N-(2-hydroxyethyl)tallowamine, N,N-bis(2-hydroxyethyl) aliphatic amines such as N,N-bis(2-hydroxyethyl)laurylamine, N,N-bis(2-hydroxyethyl)tridecylamine, N,N-bis(2-hydroxyethyl)myristylamine, N,N-bis(2-hydroxyethyl)pentadecylamine, N,N-bis(2-hydroxyethyl)palmitylamine, N,N-bis(2-hydroxyethyl)stearylamine, N,N-bis(2-hydroxyethyl)oleylamine, N,N-bis(2-hydroxyethyl)docosylamine, N,N-bis(2-hydroxyethyl)octacosylamine, N,N-bis(2-hydroxyethyl)cocoamine, and N,N-bis(2-hydroxyethyl)tallowamine, mono- or diesters of the N,N-bis(2-hydroxyethyl) aliphatic amines with fatty acids such as lauric acid, myristic acid, palmitic acid, stearic acid, oleic acid, behenic acid, and erucic acid, polyoxyethylene aliphatic amino ethers such as polyoxyethylene lauryl amino ether, polyoxyethylene stearyl amino ether, polyoxyethylene oleyl amino ether, polyoxyethylene coco amino ether, and polyoxyethylene tallow amino ether, mono- or diesters of the polyoxyethylene aliphatic amino ethers with the above-described fatty acids,

N-(lauroyloxyethyl)-N-(stearoyloxyethoxyethyl)stearylamine, N,N,N',N'-tetra(2-hydroxyethyl)-1,6-diaminohexane, N-lauryl-N,N',N'-tris(2-hydroxyethyl)-1,3-diaminopropane, N-stearyl-N,N',N'-tris(2-hydroxyethyl)-1,3-diaminopropane, N-coco-N,N',N'-tris(2-hydroxyethyl)-1,3-diaminopropane, N-tallow-N,N',N'-tris(2-hydroxyethyl)-1,3-diaminopropane, N,N-dicoco-N',N'-bis(2-hydroxyethyl)-1,3-diaminopropane, N,N-ditallow-N',N'-bis(2-hydroxyethyl)-1,3-diaminopropane, N-coco-N,N',N'-tris(2-hydroxyethyl)-1,6-diaminohexane, N-tallow-N,N',N'-tris(2-hydroxyethyl)-1,6-diaminohexane, N,N-dicoco-N',N'-bis(2-hydroxyethyl)-1,6-diaminohexane, N,N-ditallow-N',N'-bis(2-hydroxyethyl)-1,6-diaminohexane, N-(2-hydroxyethyl)-2-hydroxylaurylamine, N-(2-hydroxyethyl)-2-hydroxymyristylamine, N-(2-hydroxyethyl)-2-hydroxypalmitylamine, N-(2-hydroxyethyl)-2-hydroxystearylamine, N,N-bis(2-hydroxyethyl)-2-hydroxylaurylamine, N,N-bis(2-hydroxyethyl)-2-hydroxymyristylamine, N,N-bis(2-hydroxyethyl)-2-hydroxypalmitylamine, N,N-bis(2-hydroxyethyl)-2-hydroxystearylamine, 2,2'-bis(lauramide)diethylamine, 2,2'-bis(myristamide)diethylamine, 2,2'-bis(palmitamide)diethylamine, 2,2'-bis(stearamide)diethylamine, N-(2-(lauramide))ethyl-N-(2'-(stearamide))ethylamine, N-(2-(myristamide))ethyl-N-(2'-(stearamide))ethylamine, N-(3-(lauramide))propyl-N,N-dimethylamine, N-(3-(myristamide))propyl-N,N-dimethylamine, N-(3-(palmitamide))propyl-N,N-dimethylamine, N-(3-(stearamide))propyl-N,N-dimethylamine, N-(3-(lauroyloxy))propyl-N,N-dimethylamine, N-(3-(myristoyloxy))propyl-N,N-dimethylamine, N-(3-(palmitoyloxy))propyl-N,N-dimethylamine, N-(3-(stearoyloxy))propyl-N,N-dimethylamine, N,N-bis(3-(lauramide)propyl)methylamine, N,N-bis(3-(myristamide)propyl)methylamine, N,N-bis(3-(palmitamide)propyl)methylamine, and N,N-bis(3-(stearamide)propyl)methylamine.

The basic nitrogen compound having, in a molecule, at least one straight-chain hydrocarbon group having 5 to 28 carbon atoms can be, for example, a basic nitrogen compound represented by the following formula (b): 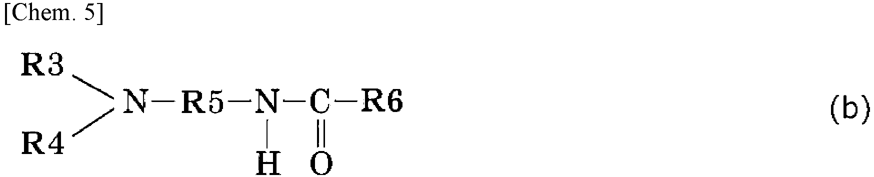
wherein R3 and R4 each independently represent CH₃, C₂H₅, HOCH₂, HOC₂H₄, or HOCH₂CH(CH₃),
R5 represents C₂H₄ or C₃H₆, and
R6 represents an alkyl group having 11 to 21 carbon atoms. In the formula, "δ+", "(+)", "(-)", "→", and "----" respectively have the above-described definitions.

Examples of the basic nitrogen compound represented by formula (b) include compounds represented by the following formulas (b-1) to (b-7):

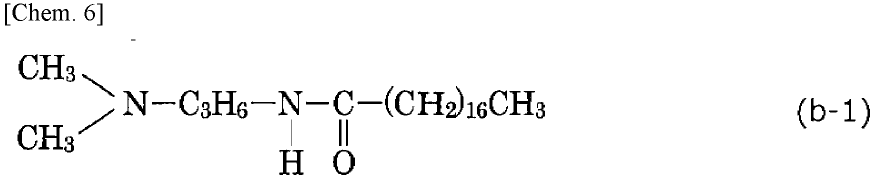

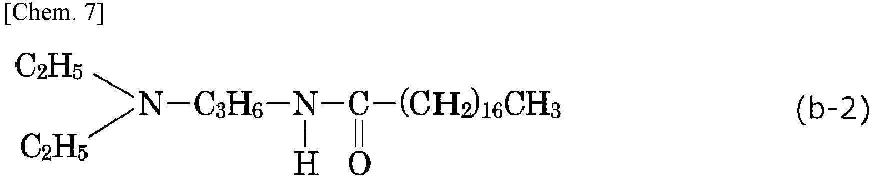

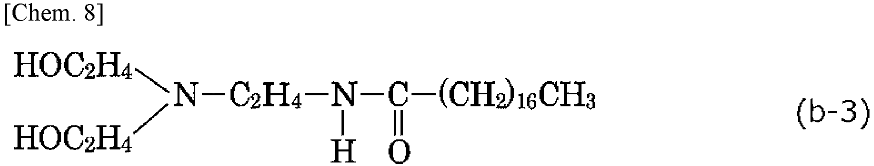

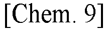

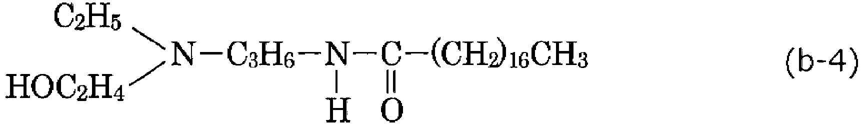

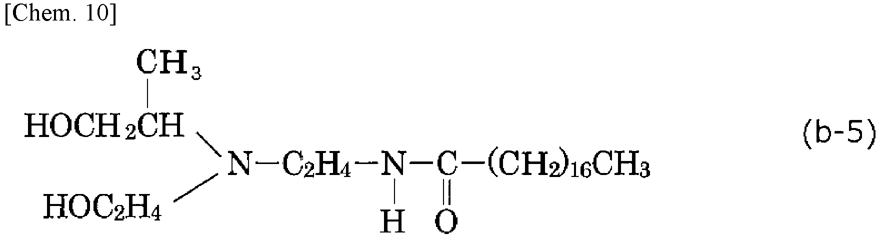

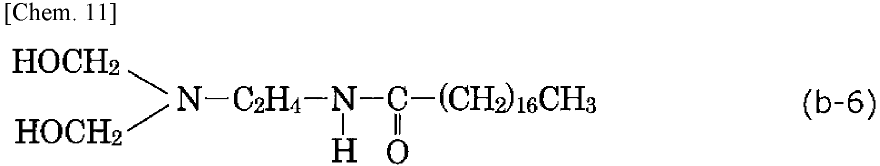

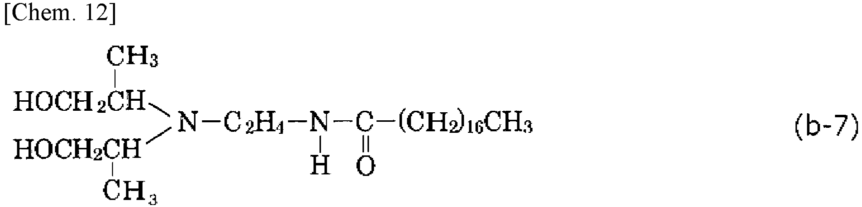

The molecular compound composed of the organic boron-based donor component and the organic nitrogen-based acceptor component can be, for example, a compound represented by the following formula (1): 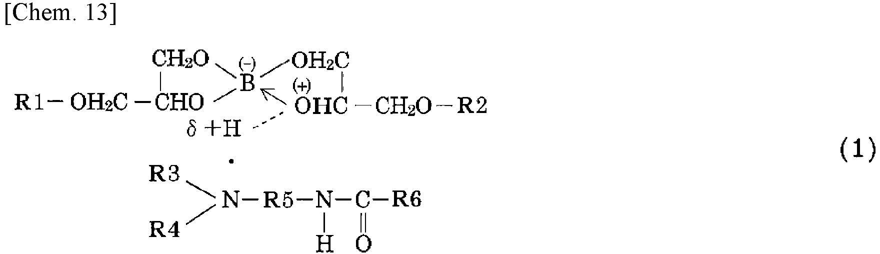
wherein R1 and R2 each independently represent a hydrogen atom, or -CO-R7,
at least one of R1 and R2 represents -CO-R7,
R7 represents an alkyl group having 11 to 21 carbon atoms,
R3 and R4 each independently represent CH₃, C₂H₅, HOCH₂, HOC₂H₄, or HOCH₂CH(CH₃),
R5 represents C₂H₄ or C₃H₆, and
R6 represents an alkyl group having 11 to 21 carbon atoms. In the formula, "δ+", "(+)", "(-)", "→", and "----" respectively have the above-described definitions.

The compound represented by formula (1) may be, for example, a compound obtained by combining at least one selected from the group consisting of formulas (a-1) and (a-2), and at least one selected from the group consisting of formulas (b-1) and (a-9), and from the viewpoint of antistatic properties, is preferably a compound represented by any of the following formulas (1-1) to (1-8):

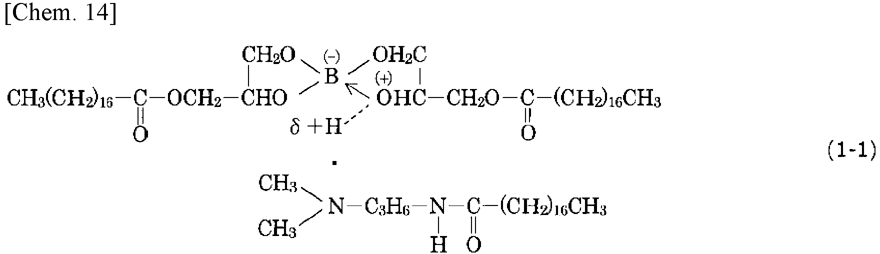

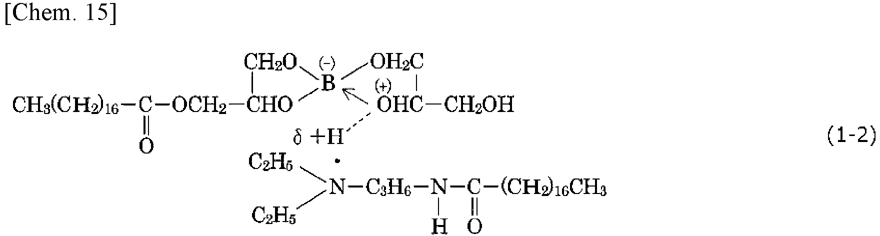

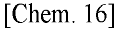

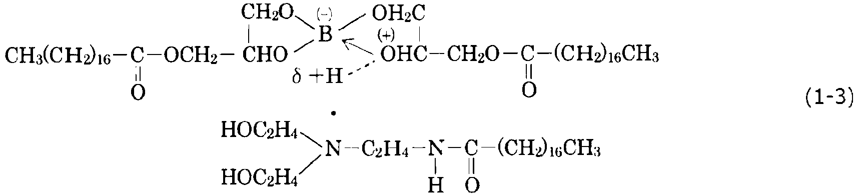

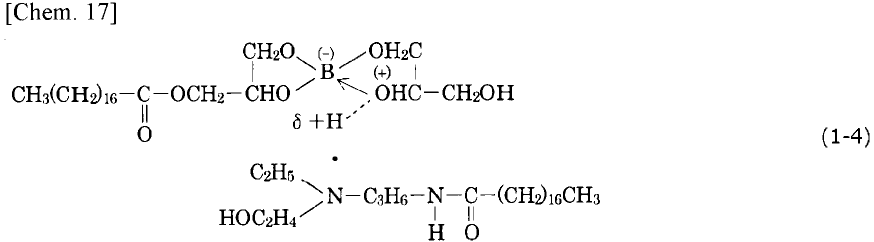

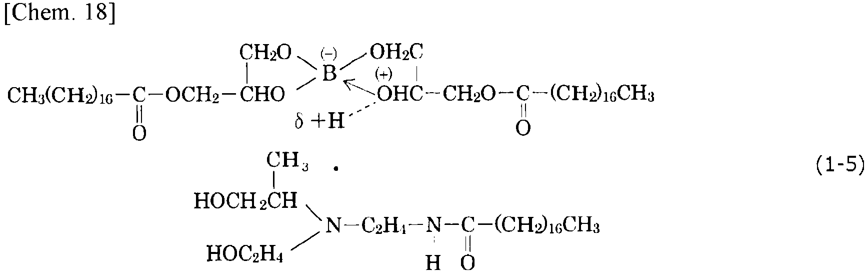

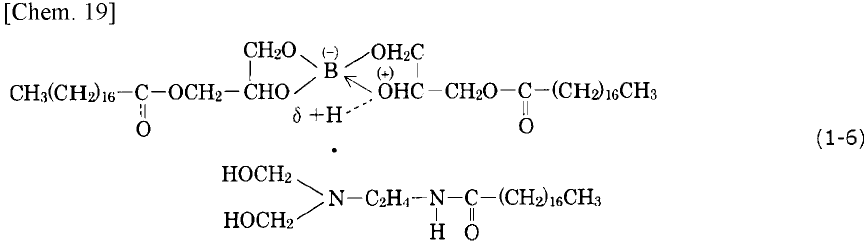

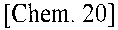

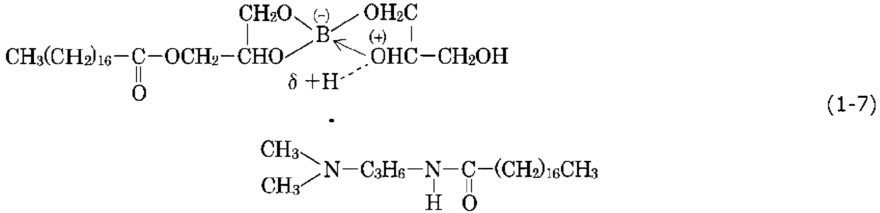

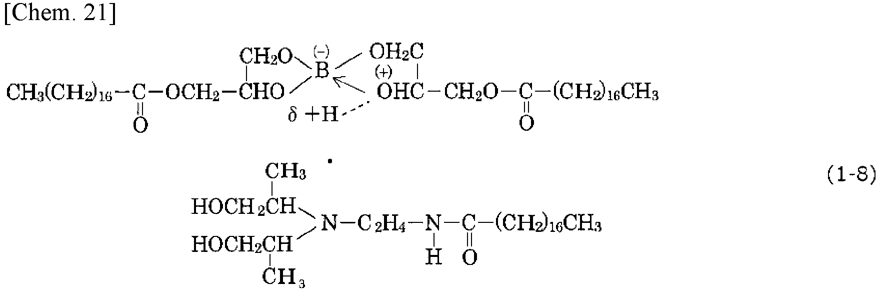

As the donor-acceptor type molecular compound, a commercially available product can be used. Examples of the commercially available product include those available under trade names "Biomicelle BN-105" and "Biomicelle SIS-105" manufactured by Boron Laboratory Co., Ltd.

The donor-acceptor type molecular compound may be blended in the rubber composition for a seal material in a state where it is carried on a carrier such as silica.

From the viewpoint of the antistatic properties, the rubber composition for a seal material may contain the donor-acceptor type molecular compound in an amount of, for example, 100 parts by mass or less based on 100 parts by mass of the crosslinkable rubber component, and contains it in an amount of preferably 0.01 to 50 parts by mass, more preferably 0.05 to 30 parts by mass, further preferably 0.1 to 10 parts by mass, particularly preferably 0.5 to 5 parts by mass, and extremely preferably 1 part by mass to 4 parts by mass. The content of the donor-acceptor type molecular compound encompasses the mass of silica when the donor-acceptor type molecular compound is carried on the silica. When the donor-acceptor type molecular compound is carried on silica, the mass ratio between the donor-acceptor type molecular compound and the silica may be, for example, 0.001:1 to 1:0.001.

### (2) Crosslinkable Rubber Component

The crosslinkable rubber component can form an elastomer having a crosslinked structure (crosslinked rubber) through a crosslinking reaction. The crosslinkable rubber component can contain at least one selected from the group consisting of a perfluoroelastomer (FFKM) and a fluororubber (FKM). In the rubber composition for a seal material, one of these crosslinkable rubber components may be used alone or two or more of thereof may be used in combination. From the viewpoint of plasma resistance, the crosslinkable rubber component preferably contains a perfluoroelastomer (FFKM), and more preferably contains only a perfluoroelastomer (FFKM).

The perfluoroelastomer is not especially limited, and examples thereof include a tetrafluoroethylene (TFE)-perfluoro(alkyl vinyl ether)-based copolymer, and a TFE-perfluoro(alkoxyalkyl vinyl ether)-based copolymer. Such a copolymer may further contain a structural unit derived from another perfluoromonomer. When a perfluoroelastomer composition containing a perfluoroelastomer is used, the plasma resistance can be further improved as compared with a case where the rubber composition for a seal material contains a hydrogen atom-containing fluorine elastomer. The rubber composition for a seal material may contain only one perfluoroelastomer, or may contain two or more thereof.

Perfluoro(alkyl vinyl ether) contained in a tetrafluoroethylene (TFE)-perfluoro(alkyl vinyl ether)-based copolymer may contain an alkyl group having 1 to 5 carbon atoms, and can be, for example, perfluoro(methyl vinyl ether), perfluoro(ethyl vinyl ether), or perfluoro(propyl vinyl ether). It is preferably perfluoro(methyl vinyl ether).

In perfluoro(alkoxyalkyl vinyl ether) contained in a TFE-perfluoro(alkoxyalkyl vinyl ether)-based copolymer, a group bonded to a vinyl ether group (CF₂=CFO-) may have 3 to 12 carbon atoms, and for example, it can be: CF₂=CFOCF₂CF(CF₃)OCₙF₂ₙ₊₁,

CF₂=CFO(CF₂)₃OCₙF₂ₙ₊₁,

CF₂=CFOCF₂CF(CF₃)O(CF₂0)ₘCₙF₂ₙ₊₁,

or
CF₂=CFO(CF₂)₂OCₙF₂ₙ₊₁, wherein n is, for example, 1 to 5, and m is, for example, 1 to 3.

The perfluoroelastomer preferably has crosslinkability, and more specifically, is preferably one obtained by further copolymerizing a crosslinking site monomer (one further containing a structural unit derived from a crosslinking site monomer). A crosslinking site means a site capable of crosslinking reaction. Examples of the crosslinking site include a nitrile group, a halogen group (e.g., an I group, or a Br group), and a perfluorophenyl group.

One example of a crosslinking site monomer having a nitrile group as the crosslinking site is a nitrile group-containing perfluorovinyl ether. Examples of the nitrile group-containing perfluorovinyl ether include
CF₂=CFO(CF₂)ₙOCF(CF₃)CN (wherein n is, for example, 2 to 4),
CF₂=CFO(CF₂)ₙCN (wherein n is, for example, 2 to 12),
CF₂=CFO[CF₂CF(CF₃)O]ₘ(CF₂)ₙCN (wherein n is, for example, 2, and m is, for example, 1 to 5),
CF₂=CFO[CF₂CF(CF₃)O]ₘ(CF₂)ₙCN (wherein n is, for example, 1 to 4, and m is, for example, 1 to 2), and
CF₂=CFO[CF₂CF(CF₃)O]ₙCF₂CF(CF₃)CN (wherein n is, for example, 0 to 4).

One example of a crosslinking site monomer having a halogen group as the crosslinking site is a halogen group-containing perfluorovinyl ether. Examples of the halogen group-containing perfluorovinyl ether include those obtained by, in the specific examples of the nitrile group-containing perfluorovinyl ether described above, replacing the nitrile group with a halogen group.

A crosslinkable perfluoroelastomer may have a crosslinked structure crosslinked between two main chains.

A ratio, in the perfluoroelastomer, of TFE-derived structural unit/perfluoro(alkyl vinyl ether) or perfluoro(alkoxyalkyl vinyl ether)-derived structural unit/crosslinking site monomer-derived structural unit is, in terms of a molar ratio, usually 50 to 79.6%/20 to 49.8%/0.2 to 5%, and is preferably 60 to 74.8%/25 to 39.5%/0.5 to 2%. The rubber composition for a seal material may also contain two or more perfluoroelastomers different in the ratio of these structural units.

Examples of the fluororubber include binary vinylidene fluoride-based rubber such as a vinylidene fluoride/hexafluoropropylene copolymer, tertiary vinylidene fluoride-based rubber such as a vinylidene fluoride/tetrafluoroethylene/hexafluoropropylene copolymer, a vinylidene fluoride/tetrafluoroethylene/perfluoroalkyl vinyl ether copolymer, or a vinylidene fluoride/tetrafluoroethylene/propylene copolymer, a tetrafluoroethylene/propylene copolymer, an ethylene/tetrafluoroethylene/perfluoromethyl vinyl ether copolymer, a thermoplastic fluororubber, and a liquid fluororubber having a perfluoropolyether skeleton (e.g., "SIFEL (R)" manufactured by Shin-Etsu Chemical Co., Ltd.). One of these fluororubbers may be used alone, or two or more of these may be used in combination.

The fluororubber may contain a functional group. The functional group can be introduced by, for example, copolymerization of a crosslinking site monomer having the functional group. The crosslinking site monomer can be a halogen group-containing monomer.

The crosslinkable rubber component may further contain, in addition to the perfluoroelastomer (FFKM) and the fluororubber (FKM), another crosslinkable rubber component such as silicone rubber, fluorosilicone rubber, ethylene-propylene rubber (EPM), ethylene-propylene-diene rubber (EPDM), nitrile rubber (NBR; acrylonitrile-butadiene rubber), hydrogenated nitrile rubber (HNBR; hydrogenated acrylonitrile-butadiene rubber), butyl rubber (IIR), or acrylic rubber.

### (3) Other Components

The rubber composition for a seal material can optionally contain, together with a co-crosslinking agent (crosslinking aid), a crosslinking agent in accordance with the crosslinking system of the crosslinkable rubber component. The rubber composition for a seal material may be crosslinked by any one of crosslinking systems, or crosslinked by two or more crosslinking systems.

The crosslinking system of a perfluoroelastomer is at least one selected from the group consisting of a peroxide crosslinking system, a triazine crosslinking system, an oxazole crosslinking system, an imidazole crosslinking system, a thiazole crosslinking system, and a bisphenol crosslinking system. One of these crosslinking systems of a perfluoroelastomer may be used alone, or two or more of these may be used in combination.

The crosslinking system of vinylidene fluoride-based rubber and tetrafluoroethylene-propylene rubber is at least one selected from the group consisting of a peroxide crosslinking system, a polyamine crosslinking system, and a polyol crosslinking system. One of these crosslinking systems of vinylidene fluoride-based rubber and tetrafluoroethylene-propylene rubber may be used alone, or two or more of these may be used in combination.

A peroxide crosslinking agent can be, for example, 2,5-dimethyl-2,5-di(t-butylperoxy)hexane (examples of commercially available product: "PERHEXA 25B" and "PERHEXA 25B-40" manufactured by NOF Corporation); dicumyl peroxide (example of commercially available product: "PERCUMYL D" manufactured by NOF Corporation); 2,4-dichlorobenzoyl peroxide; di-t-butyl peroxide; t-butyl dicumyl peroxide; benzoyl peroxide (example of commercially available product: "NYPER B" manufactured by NOF Corporation); 2,5-dimethyl-2,5-(t-butylperoxy)hexyne-3 (example of commercially available product: "PERHEXYNE 25B" manufactured by NOF Corporation); 2,5-dimethyl-2,5-di(benzoylperoxy)hexane; α,α'-bis(t-butylperoxy-m-isopropyl)benzene (example of commercially available product: "PERBUTYL P" manufactured by NOF Corporation); t-butylperoxy isopropyl carbonate; and parachlorobenzoyl peroxide. One of these peroxide crosslinking agents may be used alone, or two or more of these may be used in combination.

Examples of the co-crosslinking agent used in the peroxide crosslinking system include compounds capable of co-crosslinking by a radical (unsaturated polyfunctional compounds), such as triallyl isocyanurate (example of commercially available product: "TAIC" manufactured by Mitsubishi Chemical Corporation); triallyl cyanurate; triallyl formal; triallyl trimellitate; N,N'-m-phenylene bismaleimide; dipropargyl terephthalate; diallyl phthalate; and tetraallyl terephthalamide. One of these co-crosslinking agents may be used alone, or two or more of these may be used in combination. Among the compounds described above, the co-crosslinking agent preferably contains triallyl isocyanurate from the viewpoints of reactivity and heat resistance (compression set properties).

In the triazine crosslinking system, a crosslinking catalyst such as an organic tin compound, an onium salt such as a quaternary phosphonium salt or a quaternary ammonium salt, urea, or silicon nitride is used.

Examples of a crosslinking agent used in the oxazole crosslinking system include 2,2-bis(3-amino-4-hydroxyphenyl)hexafluoropropane (BOAP), 4,4'-sulphonylbis(2-aminophenol), and 9,9-bis(3-amino-4-hydroxyphenyl)fluorene. BOAP is preferably used.

As a crosslinking agent used in the imidazole crosslinking system or the thiazole crosslinking agent, those conventionally known can be used. Examples of the crosslinking agent used in the imidazole crosslinking system include 3,3',4,4'-tetraaminobenzophenone, and 3,3'-diaminobenzidine.

The content of the crosslinking agent (the total amount when two or more agents are used) in the rubber composition for a seal material is, for example, 0.1 parts by mass or more and 10 parts by mass or less, preferably 0.2 parts by mass or more and 5 parts by mass or less, and more preferably 0.3 parts by mass or more and 3 parts by mass or less based on 100 parts by mass of the total amount of the crosslinkable rubber component.

The content of the co-crosslinking agent (the total amount when two or more agents are used) in the rubber composition for a seal material is, for example, 0.5 parts by mass or more and 10 parts by mass or less, and from the viewpoint of improvement of heat resistance, preferably 1 part by mass or more and 8 parts by mass or less based on 100 parts by mass of the total amount of the crosslinkable rubber components.

The rubber composition for a seal material may contain, for the purpose of improvement of processability, adjustment of physical properties, and the like, additives such as an anti-aging agent, an antioxidant, a vulcanization accelerator, a processing aid (such as stearic acid), a stabilizer, a tackifier, a silane coupling agent, a plasticizer, a flame retardant, a mold release agent, a wax, and a lubricant, if necessary. Another example of the additives includes a tack reducing (preventing) agent such as a fluorine-based oil (e.g., perfluoroether). One of these additives may be used alone, or two or more of these may be used in combination.

When the seal material is to be used in a high temperature environment or the like, however, volatilization, elution, or precipitation may be caused, and hence, the amount of the additives is preferably as small as possible (for example, is 10 parts by mass or less, preferably 5 parts by mass or less, more preferably 2 parts by mass or less, and further preferably 1 part by mass or less based on 100 parts by mass of the total amount of the crosslinkable rubber component), and it is preferable that the additives are not contained.

The rubber composition for a seal material may contain, if necessary, a colorant (e.g., an inorganic pigment or an organic pigment), and a filler (e.g., a fluororesin, silica, alumina, zinc oxide, titanium oxide, clay, talc, diatomite, barium sulfate, calcium carbonate, magnesium carbonate, calcium oxide, mica, graphite, aluminum hydroxide, aluminum silicate, hydrotalcite, a metal powder, a glass powder, or a ceramic powder). One of these fillers may be used alone, or two or more of these may be used in combination. The content of the filler (the total amount when two or more fillers are used) in the rubber composition for a seal material is, for example, 0.1 parts by mass or more and 40 parts by mass or less, and from the viewpoint of improvement of mechanical strength, preferably 1 part by mass or more and 30 parts by mass or less, and more preferably more than 1 part by mass and 30 parts by mass or less based on 100 parts by mass of the total amount of the crosslinkable rubber component. Herein, the filler is distinguished from the organic pigment and the inorganic pigment used as the colorant described above, and those different from the organic pigment and the inorganic pigment can be used.

When the rubber composition for a seal material contains a filler of a fluororesin, the ozone resistance and the mechanical strength of a crosslinked product thereof can be further improved. The fluororesin can be contained in the rubber composition for a seal material in the form of, for example, a fluororesin particle.

The fluororesin used as the filler is a resin having a fluorine atom in a molecule, and can be, for example, polytetrafluoroethylene (PTFE), a tetrafluoroethylene-perfluoroalkyl vinyl ether copolymer (PFA), a tetrafluoroethylene-hexafluoropropylene copolymer (FEP), a tetrafluoroethylene-ethylene copolymer (ETFE), polychlorotrifluoroethylene (PCTFE), a chlorotrifluoroethylene-ethylene copolymer (ECTFE), polyvinylidene fluoride (PVDF), polyvinyl fluoride (PVF), a vinylidene fluoride-hexafluoropropylene copolymer (VDF-HFP copolymer), or a vinylidene fluoride-hexafluoropropylene-tetrafluoroethylene copolymer (VDF-HFP-TFE copolymer). One of these fluororesins may be used alone, or two or more of these may be used in combination.

Among those described above, from the viewpoint of preventing the resin from melting in a high temperature environment to be impaired in compression set properties and the like, a fluororesin having a comparatively high melting point, such as PFA or PTFE, is preferably used.

The fluororesin used as the filler may contain a functional group. The functional group can be introduced by, for example, copolymerization of a monomer having the functional group. When the crosslinking site monomer described above is copolymerized as the monomer having a functional group, crosslinking between the fluororesin and the perfluoroelastomer also proceeds owing to the crosslinking agent, and hence, the mechanical strength or the like of a crosslinked product of the perfluoroelastomer composition can be further increased. An example of the fluororesin having a functional group includes nitrile group-containing polytetrafluoroethylene described in Japanese Patent Laying-Open No. 2013-177631. The fluororesin may also be a modified fluororesin like, for example, "TFM-modified PTFE" (manufactured by Dyneon).

When the rubber composition for a seal material contains a perfluoroelastomer and a filler of a fluororesin, it is possible to use a perfluoroelastomer containing a fluororesin produced by, for example, 1) a method involving kneading a perfluoroelastomer powder and a fluororesin powder using a mixing roll, 2) a method involving melt-kneading a perfluoroelastomer powder or pellet and a fluororesin powder or pellet using an apparatus such as a mixer or a twin screw extruder, or 3) a method involving adding a fluororesin during preparation of a perfluoroelastomer.

An example of the method 3) includes a method involving mixing a perfluoroelastomer aqueous dispersion and a fluororesin aqueous dispersion, both obtained by emulsion polymerization method, and then subjecting the resultant to cocoagulation to obtain a mixture of the perfluoroelastomer and the fluororesin.

The rubber composition for a seal material can be prepared by homogeneously kneading the crosslinkable rubber component, the donor-acceptor type molecular compound, and the crosslinking agent and the like added if necessary. As a kneader, those conventionally known, such as a mixing roll, a pressure kneader, and an internal mixer (Banbury mixer), can be used. The respective components to be blended may be mixed and kneaded at a time, or may be kneaded dividedly in a plurality of stages, for example, in such a manner that components, excluding a component contributing the crosslinking reaction (e.g., a crosslinking accelerator, a crosslinking retarder, or a crosslinking agent) from the respective components to be blended, are priorly homogeneously kneaded, and thereafter, the component contributing the crosslinking reaction is kneaded.

### <Seal Material>

A seal material of the present invention contains a crosslinked product of the rubber composition for a seal material described above. The seal material can be produced by crosslinking (vulcanizing) and molding the rubber composition for a seal material. As a method for crosslinking and molding, any of conventionally known methods such as injection molding, compression molding, and transfer molding can be employed.

A heating temperature in the molding (primary crosslinking temperature) may be, for example, 120°C or more and 220°C or less, and a heating time (primary crosslinking time) may be, for example, 0.5 minutes or more and 120 minutes or less. After the vulcanization and molding, secondary crosslinking may be performed. A secondary crosslinking temperature may be, for example, 120°C or more and 280°C or less, and a secondary crosslinking time may be, for example, 0.5 hours or more and 24 hours or less.

A surface potential of the seal material may be, for example, -2000 V or more, and is preferably -1500 V or more and 0 or less, and more preferably -500 V or more and 0 V or less. A seal material having a surface potential within this range tends to be excellent in antistatic properties.

The seal material of the present invention is excellent in antistatic properties, and hence can be suitably used as a gate seal or the like to be provided on a gate of a vacuum chamber. **In** particular, the seal material of the present invention can be suitably used as a gate seal used in, for example, a high temperature environment, a corrosive environment, a UV environment, or a plasma environment, such as a gate seal for a semiconductor manufacturing apparatus. The shape of the seal material of the present invention is not especially limited, and can be, for example, an O-ring shape. Examples

Now, the present invention will be described in more detail by way of examples. It is noted that "%" and "part(s)" used in the examples are "% by mass" and "part(s) by mass" unless otherwise stated.

### <Examples 1 to 12 and Comparative Examples 1 to 2>

A rubber composition for a seal material was prepared in the following manner, and a seal material was subsequently produced therefrom. First, in accordance with each blending composition shown in Table 1 (wherein a unit of the blending amount is part(s) by weight), prescribed amounts of respective agents to be blended were kneaded with an open roll. Next, the thus obtained rubber composition for a seal material was press-molded under the following conditions, and then the resultant was subjected to secondary crosslinking by heating under the following conditions to obtain a seal material (O ring):
press-molding conditions: 180°C × 20 minutes
secondary crosslinking conditions: 200°C × 4 hours

**[Table 1]**

| | | Example | | | | | | | | | | | | Comparative Example | |
|---|---|---|---|---|---|---|---|---|---|---|---|---|---|---|---|
| | | 1 | 2 | 3 | 4 | 5 | 6 | 7 | 8 | 9 | 10 | 11 | 12 | 1 | 2 |
| Polymer | FFKM1 | 100 | 100 | 100 | 100 | 100 | - | - | - | - | - | - | - | 100 | - |
| | FFKM2 | - | - | - | - | - | 100 | 100 | 100 | 100 | 100 | 100 | 100 | - | 100 |
| Crosslinking Agent | BOAP | 1 | 1 | 1 | 1 | 1 | - | - | - | - | - | - | - | 0.5 | - |
| | PERHEXA 25B | - | - | - | - | - | 1 | 1 | 1 | 1 | 1 | 1 | 1 | - | 1 |
| Crosslinking Aid | TAIC | - | - | - | - | - | 1.5 | 1.5 | 1.5 | 1.5 | 1.5 | 1.5 | 1.5 | - | 1.5 |
| Filler | PTFE | - | - | - | - | 5 | 10 | 10 | 10 | 10 | - | - | 5 | - | - |
| Donor-acceptor Type Molecular | Biomicelle SIS-105 | - | - | - | 3 | - | - | - | - | - | 1 | 5 | 1 | - | - |
| | TG-3000 | 1 | 2 | 3 | - | 1 | 1 | 2 | 3 | 4 | - | - | 1 | - | - |
| Surface Potential | | -887 | -571 | -434 | -1225 | -520 | -587 | -362 | -72 | -35 | -934 | -577 | -673 | unmea surable | unmea surable |

The details of blended components shown in Table 1 are as follows:
[FFKM 1]
perfluoroelastomer that is a tetrafluoroethylene-perfluoro(alkyl vinyl ether)-nitrile group-containing monomer copolymer ["PFE 131T" manufactured by 3M]
[FFKM2]
perfluoroelastomer that is a tetrafluoroethylene-perfluoro(alkyl vinyl ether)-halogen group-containing perfluorovinyl ether monomer copolymer ["PFR94" manufactured by Solvay]
[BOAP]
oxazole crosslinking agent, 2,2-bis(3-amino-4-hydroxyphenyl)hexafluoropropane, manufactured by Tokyo Chemical Industry Co., Ltd.
[PERHEXA 25B]
peroxide crosslinking agent, 2,5-dimethyl-2,5-di(t-butylperoxy)hexane, manufactured by NOF Corporation
[TAIC]
triallyl isocyanurate, manufactured by Mitsubishi Chemical Corporation
[PTFE]
"Lubron L5" manufactured by Daikin Industries, Ltd.
[Biomicelle SIS-105]
donor-acceptor type molecular compound containing "Biomicelle BN-105" manufactured by Boron Laboratory Co., Ltd. carried on silica
[TG-3000]
donor-acceptor type antistatic agent represented by the following formula (manufactured by Taiyo Chemicals & Engineering Co., Ltd.):

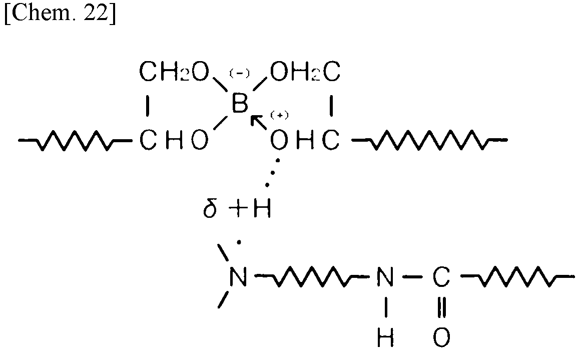

### (Evaluation of Seal Material)

The thus obtained crosslinked molded products (seal materials) were measured and evaluated for the following item. The results are shown in Table 1.

### Measurement of Surface Potential

[1] A sheet of each crosslinked molded product (seal material) having been molded into a thickness of 2 mm was discharged with an ionizer in an environment of a temperature of 23°C and a humidity of 50%, and the rubber sheet was charged by rubbing with a rag 10 times, and thereafter, the surface potential was measured with a surface potential measuring device (A.C. feedback surface potential measuring device Model 520-1, manufactured by Trek Japan Corporation). **In** Comparative Examples 1 and 2, the surface potential was beyond the detection range, and could not be measured.

The seal materials of Examples 1 to 12 containing the donor-acceptor type molecular compound had a lower surface potential than the seal materials of Comparative Examples 1 and 2 not containing the donor-acceptor type molecular compound. Accordingly, it is understood that the seal material of the present invention is difficult to be charged, and hence particle adsorption is easily inhibited in semiconductor manufacturing process.

## Claims

1. A rubber composition for a seal material, comprising a crosslinkable rubber component, and a donor-acceptor type molecular compound.

2. The rubber composition for a seal material according to claim 1, wherein the donor-acceptor type molecular compound is a molecular compound composed of an organic boron-based donor component and an organic nitrogen-based acceptor component.

3. The rubber composition for a seal material according to claim 2,
wherein the molecular compound composed of an organic boron-based donor component and an organic nitrogen-based acceptor component is represented by the following formula (1): 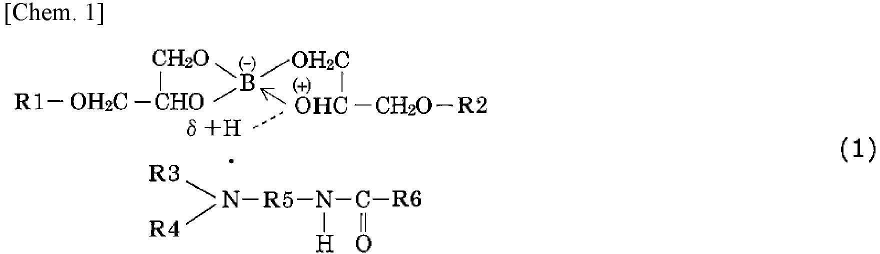 wherein
R1 and R2 each independently represent a hydrogen atom or -CO-R7,
at least one of R1 and R2 represents -CO-R7,
R7 represents an alkyl group having 11 to 21 carbon atoms,
R3 and R4 each independently represent CH₃, C₂H₅, HOCH₂, HOC₂H₄, or HOCH₂CH(CH₃),
R5 represents C₂H₄ or C₃H₆, and
R6 represents an alkyl group having 11 to 21 carbon atoms.

4. The rubber composition for a seal material according to any one of claims 1 to 3, wherein the rubber composition comprises 0.05 to 30 parts by mass of the donor-acceptor type molecular compound based on 100 parts by mass of the crosslinkable rubber component.

5. The rubber composition for a seal material according to any one of claims 1 to 3, wherein the crosslinkable rubber component comprises at least one selected from the group consisting of a perfluoroelastomer and a fluororubber, and the perfluoroelastomer has a structural unit derived from a crosslinking site monomer.

6. The rubber composition for a seal material according to claim 5, wherein a crosslinking system of the perfluoroelastomer is at least one selected from the group consisting of a peroxide crosslinking system, a triazine crosslinking system, an oxazole crosslinking system, an imidazole crosslinking system, a thiazole crosslinking system, and a bisphenol crosslinking system.

7. The rubber composition for a seal material according to any one of claims 1 to 3, further comprising a filler, wherein the filler comprises polytetrafluoroethylene.

8. The rubber composition for a seal material according to claim 4, further comprising a filler, wherein the filler comprises polytetrafluoroethylene.

9. The rubber composition for a seal material according to claim 5, further comprising a filler, wherein the filler comprises polytetrafluoroethylene.

10. The rubber composition for a seal material according to any one of claims 1 to 3, wherein a surface potential [V] of the rubber composition for a seal material after crosslinking is -2000 V or more.

11. The rubber composition for a seal material according to claim 4, wherein a surface potential [V] of the rubber composition for a seal material after crosslinking is -2000 V or more.

12. The rubber composition for a seal material according to claim 5, wherein a surface potential [V] of the rubber composition for a seal material after crosslinking is -2000 V or more.

13. A seal material, comprising a crosslinked product of the rubber composition for a seal material according to any one of claims 1 to 3.

14. A seal material, comprising a crosslinked product of the rubber composition for a seal material according to claim 5.

15. An O ring, comprising the seal material according to claim 13.

16. An O ring, comprising the seal material according to claim 14.

17. A member for a semiconductor manufacturing apparatus, comprising the seal material according to claim 13.

18. A member for a semiconductor manufacturing apparatus, comprising the seal material according to claim 14.

19. A seal material for a semiconductor manufacturing apparatus, comprising the seal material according to claim 13.

20. A seal material for a semiconductor manufacturing apparatus, comprising the seal material according to claim 14.
